# EUROPEAN PATENT SPECIFICATION

(11) **EP 2 593 592 B1**
(45) Date of publication and mention of the grant of the patent: **16.05.2018**
(21) Application number: 11745502.2
(22) Date of filing: 13.07.2011
(51) Int. Cl.: C25D 5/02, C25D 17/12, H01L 21/683, H01L 21/67, C25D 1/20, C25D 1/00, C25D 7/12

(54) **SEPARATION OF MASTER ELECTRODE AND SUBSTRATE IN ECPR**
TRENNUNG EINER MASTERELEKTRODE UND EINES SUBSTRATS BEI EINEM ECPR-VERFAHREN
SÉPARATION D'UNE ÉLECTRODE PRINCIPALE ET D'UN SUBSTRAT DANS UN PROCÉDÉ ECPR

(30) Priority: 16.07.2010 US 364989 P; 15.07.2010 SE 1050798
(43) Date of publication of application: 22.05.2013
(73) Proprietor: Luxembourg Institute of Science and Technology (LIST), 4362 Esch-sur-Alzette (LU)
(72) Inventor: MÖLLER, Patrik, S-112 32 Stockholm (SE); FREDENBERG, Mikael, S-112 45 Stockholm (SE); UTTERBÄCK, Tomas, S-762 61 Rimbo (SE); SANTOS, Antonio, S-164 45 Kista (SE); CHAUVET, Jean-Michel, S-125 43 Älvsjö (SE); ROSÉN, Daniel, S-112 44 Stockholm (SE); SVENSSON, Stefan, S-182 31 Danderyd (SE)
(74) Representative: Lecomte & Partners
(86) International application number: PCT/EP2011/061992
(87) International publication number: WO 2012/007522

(56) References cited:
- WO-A1-98/45504
- WO-A1-98/45504
- WO-A1-2007/058603
- JP-A- 2010 250 940
- US-A1- 2009 229 855
- US-A1- 2009 229 855
- US-B2- 6 870 301
- US-B2- 6 870 301

## Description

### Field of the Invention

This invention pertains in general to the field of electrochemical pattern replication. More particularly the invention relates to a method for separation of a master electrode and a substrate in ECPR.

### Background of the Invention

Electroplating/electroetching is used for microelectronics in a wide range of applications, such as interconnects, components, waveguides, inductors, contact pads etc.

In the field of microelectronics electroplating/electroetching is suitable for applications involving production of micro and nano structures in single or multiple layers, fabrication of PWB (printed wiring boards), PCB (printed circuit boards), MEMS (micro electro mechanical systems), IC (integrated circuit) interconnects, above IC interconnects, sensors, flat panel displays, magnetic and optical storage devices, solar cells and other electronic devices. It can also be used for different types of structures in conductive polymers, structures in semiconductors, structures in metals, and others. Even 3D-structures in silicon, such as by formation of porous silicon, are possible.

Chemical vapour deposition and physical vapour deposition are processes that may also be used for metallization, but electroplating/electroetching is often preferred since it is generally less expensive than other metallization processes and it can take place at ambient temperatures and at ambient pressures.

Electroplating/electroetching of a work piece takes place in a reactor containing an electrolyte. An anode, carrying the metal to be plated, is connected to a positive voltage. In some cases, the anode is inert and the metal to be plated comes from the ions in the electrolyte. The conductivity of the work piece, such as a semiconductor substrate, is generally too low to allow the structures to be plated to be connected through the substrate to backside contacts. Therefore, the structures to be plated first have to be provided with a conductive layer, such as a seed layer. Leads connect the pattern to finger contacts on the front side. The finger contacts are in turn connected to a negative voltage. The electroplating step is an electrolytic process where the metal is transferred from the anode, or from the ions in the electrolyte, to the conductive pattern (cathode) by the electrolyte and the applied electric field between the anode and the conductive layer on the work piece, which forms the cathode.

The ever-increasing demand for smaller, faster and less expensive microelectronic and micro-electromechanical systems requires corresponding development of efficient and suitable manufacturing techniques, which has resulted in the development of electrochemical pattern replication (ECPR).

In ECPR plating/etching cells or cavities are formed between a master electrode and the substrate, said cavities being defined by a conductive surface on the master electrode, an insulating material, defining the pattern to be plated/etched, and the conductive surface of the substrate. During plating, a predeposited anode material has been arranged, normally through electrochemical plating, in the cavities. The master electrode and the substrate are put in close contact with each other in the presence of an electrolyte, suitable for the intended purpose, such that the electrolyte is "trapped" in the ECPR plating/etching cavities. WO 02/103085, to the present inventors, describes a system of this kind.

During ECPR, after the substrate has been plated or etched, there is a problem in separating the master electrode and the substrate. More particularly, the plated structures arranged on the substrate within the cavities of the master electrode, tends to interact with the insulating material on the master electrode. Also, the capillary force in the electrolyte present in the cavities severely hampers the separation process. WO2007058603 mentions a method of separating the master electrode from the substrate in a non parallel manner in order to ease the separation.

### Summary of the Invention

Accordingly, the present invention preferably seeks to mitigate, alleviate or eliminate one or more of the above-identified deficiencies in the art and disadvantages singly or in any combination. At least these problems are solved by a method for separating a master electrode and a substrate in an ECPR process after printing, the master electrode or the substrate being arranged on a first chuck and the other one of said master electrode and the substrate being arranged on a second chuck, said master electrode and substrate having a planar interaction area during printing , said method comprising (i) initiating separation at the edge of the master electrode and the substrate, and pulling a front side of the master electrode apart from a front side of the substrate such that the interaction area between the master electrode and the substrate is decreased continuously from the periphery of the master electrode and the substrate towards a centre of the master electrode or substrate. In some embodiments, the method further comprises (ii) providing a horizontal gas flow towards the interface between the master electrode and the substrate while decreasing the interaction area; or (iii) lowering the temperature from the temperature of the master and substrate before decreasing the interaction area; or (iv) reversing the direction of current in relation to the current direction during plating before decreasing the interaction area; or (v) performing printing in the ECPR process in a sealed ECPR chamber at a first pressure, and the pressure in the ECPR chamber is increased in relation to said first pressure before or while decreasing the interaction area; or (vi) combinations of these.

### Brief Description of the Drawings

These and other aspects, features and advantages of which the invention is capable of will be apparent and elucidated from the following description of embodiments of the present invention, reference being made to the accompanying drawings, in which
Fig. 1 discloses an arrangement according to one embodiment of the present invention; and
Fig. 2 discloses an arrangement not part of the present invention.

### Description of embodiments

The following description focuses on embodiments of the present invention applicable to a method for separating a master electrode and a substrate during ECPR.

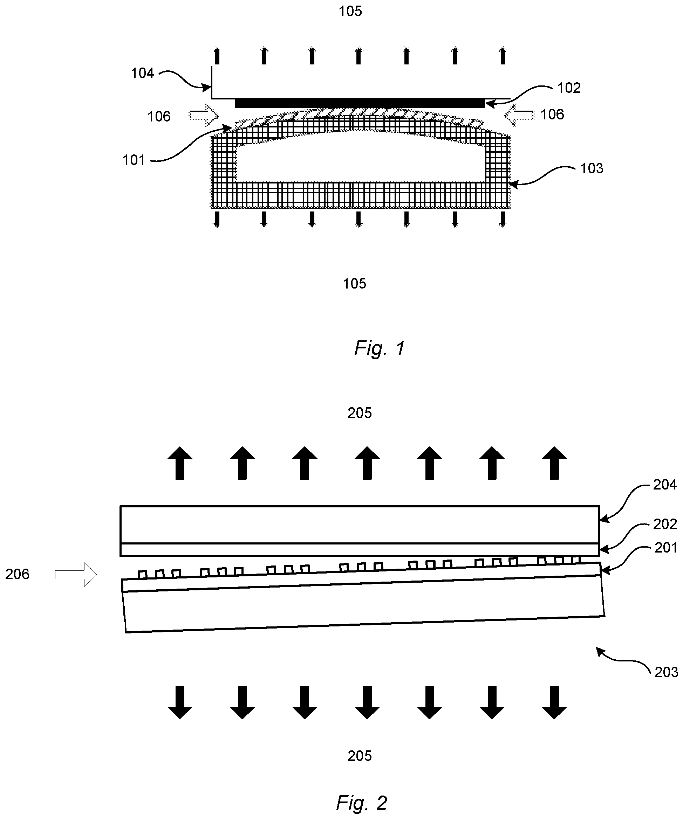

Fig. 1 discloses a system for ECPR in a position where separation of the master electrode and the substrate has been initiated.

During ECPR the master electrode 101 and the substrate 102 are arranged in an ECPR chamber on a lower and upper chuck 103, 104, respectively, which are brought together by the operation of a suitable mechanics and/or software. The master electrode 101 and the substrate 102 may be fixated onto the lower chuck 103 and upper chuck 104, respectively, by means of the applied vacuum between these. The ECPR chamber is the chamber wherein ECPR is intended to take place. An electrolyte is provided in between the master electrode 101 and the substrate 102, and is sealed within the ECPR chamber by suitable seals and pieces creating the ECPR chamber. The chamber is provided with necessary electric leads (not shown) to the conductive layer of the master electrode 101 and the seed layer on the substrate 102. The chamber is also provided with conduits (not shown) for guiding electrolyte to and from the chamber. Subsequently, after loading the master electrode 101 and the substrate 102 on the lower chuck 103 and the upper chuck 104, respectively, the chucks 103, 104 are brought together, such that the master electrode 101 and the substrate 102 are brought into contact and being aligned in parallel with each other. Then, anode material positioned in the cavities of the master electrode is transferred to the substrate electrochemically. When the intended amount of material has been plated on the substrate, the electrochemical process is stopped by ceasing the power supply creating the electrochemical cells between the master electrode and the substrate. Then the master electrode and the substrate are separated.

In the method according to the present invention the separation is performed by initiating the separation by separating the master electrode 101 and the substrate 102 by pulling them apart by force 105, in a manner such that the interaction surface of a front side of the master electrode 101, carrying the patterned insulating layer forming a pattern of conductive cavities, and the surface of a front side of the substrate 102, being the side of the substrate being pattern during ECPR, by continuously decreasing the contact area between the front sides from the borders thereof.

This may be accomplished by adapting the lower chuck 103 such that the master electrode 101, and thereby the front side of the master electrode is slightly bent into a convex form before pushing the master electrode 101 and the substrate 102 together, and that this inherent convex shape of the chuck 103 and the master electrode 101 will initiate the separation between the master electrode 101 and the substrate 102 at the borders thereof, i.e. at the circumference thereof. The compensation of the convex shape of the master electrode 101 or substrate 102 from lower and upper chucks 103, 104, respectively, may be obtained with a resilient, flexible sheet behind the master electrode 101 or the substrate 102, or by inflating the lower or upper chuck 103, 104 before bringing the master electrode 101 and the substrate 102 together and during printing while overcoming the inflating pressure by squeezing the master electrode 101 and the substrate 102 together during printing with a force greater than the inflation pressure. The inflation will however strive after the convex shape during separation, whereby separation may be initiated at the borders of the master electrode 101 or substrate 102.

The master electrode 101 is bent by a convex shape of the lower chuck 103, and how, during movement of the upper chuck 103 and the lower chuck 104 from each other, while the master electrode goes from being planar during ECPR and strives towards its bent/convex shape, initiates separation at the periphery of the master electrode 101 and the substrate 102, while continuously decreasing the contact area between the two. Thus, the macro scale convex shape improves the separation between the master and the substrate, since capillary forces are the weakest at the edge of the master electrode and the substrate. The force holding the master electrode 101 and the substrate 102 together is spread over the contact area between the two. By separating from the edge the entire force, holding the master electrode 101 and the substrate 102 together, does not need to be overcome in one step. Instead, the force may be overcome part by part, by overcoming the force continuously from the edge. Thus, the separation process is improved.

The initiation of separation between the master electrode 101 and the substrate 102 at the edges thereof may be accomplished by a dome shaped or convex surface the lower chuck 103 or the upper chuck 104, i.e. having a convex Euclidean space in the macro scale in between the upper surface and a plane perpendicular to the central axis, i.e. the vertical axis, of the lower or upper chuck 103, 104, said upper surface intersecting said plane in a closed line.

When separated the master electrode 101 is pulled in a downward direction 105 from the substrate 102 by means of an external pulling source (not shown). Alternatively, the substrate 102 is pulled in a downward direction 105 from the master electrode 101 by means of an external pulling source (not shown). Hence, a first separation point is initiated at the border of the master electrode 101 and the border of the substrate 102. As the pulling force 105 continues, the master electrode 101 or substrate 102 will strive towards its convex shape. During this process, the contact area between the master electrode 101 and the substrate 102 will decrease continuously towards the centre of the master electrode/substrate sandwich. Hence, separation is initiated at the points of contact where the capillary forces are the weakest, while simultaneously not having to overcome the entire force at once. Using electrolytes based on substantially incompressible solvents, such as water, in order to allow the contact areas to decrease continuously it is preferred to continuously supply additional volumes of fluid or gas into the interface volume being formed between the two interaction surfaces as they are separated. In an example not part of the present invention, as disclosed in Fig. 2, the lower chuck 203 may be adapted for arranging the front side master electrode 201, such that the plane of extension thereof is slightly angled with respect to the plane of extension of the front side of the substrate 202, and that a cushion element on the backside the master electrode will compensate for this difference in vertical position once the master electrode 201 and the substrate 202 are in printing position.. In this embodiment, the ECPR equipment includes a process chamber with two planar polished chucks 203, 204 onto which the master electrode 201 and the substrate 202, respectively, are attached to. The lower chuck 203 and the upper chuck 204 are facing each other and they both may have vacuum channels (not shown) to provide a reliable fixation of the master electrode 201 and the substrate 202.

After loading the master electrode 201 on the lower chuck 203, vacuum is applied by means of the vacuum channels to fixate the master electrode 201. After loading the substrate 202 on the upper chuck 204, the interface between the substrate and the master electrode is filled up with electrolyte. Subsequently, the chucks 203, 204 are pushed together, such that the master electrode 201 and the substrate 202 are brought into contact. The master electrode 201 and the substrate 202 are brought into contact, such that the angle in between the master electrode 201 and the substrate is continuously diminished until the master electrode 201 and the substrate 202 are in parallel. This may be accomplished by arranging a resilient and flexible material on the backside of the master electrode 201 or the substrate 202, said resilient and flexible material compensating for the change in vertical position of the different areas of the master electrode 201 or substrate 202. Thereafter, printing of the substrate is performed by ECPR.

Subsequently, lower chuck 203 and the upper chuck 204 and thus the master electrode 201 and the substrate 202 are pulled apart by a force 205. When pulling apart the master electrode 201 and the substrate 202, the master electrode 201 and the substrate 202 will strive towards their angled relationship. Thus, separation is initiated at the edge of the contact area between the master electrode 201 and the substrate 202. The separation will then continue and the contact between the master electrode 201 and the substrate 202 will decrease continuously from one edge to another. Thus, separation is facilitated because of the same reasons as above.

In another example not part of the invention at least one nozzle for providing a separation gas flow 106, 206 is provided directed horizontally towards the interface between the master electrode 101, 201 and the substrate 102, 202. Through this at least one nozzle a horizontal gas flow 106, 206 of an inert gas may be applied towards the interface between the master electrode 101, 201 and the substrate 102, 202. This gas flow may be provided simultaneously with the pulling apart forces 105, 205. Also, the gas flow 106, 206 may be provided in combination with the embodiments disclosed above in relation to Figs. 1 and 2. A suitable gas for gas flow 106, 206 may be an inert gas, such as nitrogen, helium, or argon, to minimize risk of oxidation of the different parts of the ECPR system. Air may also be used because of economical reasons. In other words, the horizontal gas flow 106, 206 is provided towards the interface between the master electrode 101, 201 and the substrate 102, 202 while decreasing the interaction area between the master electrode and the substrate.

In another example not part of the invention the master electrode 101, 201 and the substrate 102, 202 may be chilled before pulling them apart with force 105, 205.

It is also possible to lower the temperature, in relation to the temperature at which the plating occurred, of a master electrode and a substrate before separation even if the separation not is initiated at the edge of the master electrode and the substrate, in accordance with Figs. 1 and 2.

When chilled from the plating temperature, such as from ambient temperature (i.e. approximately 20 to 25 °C) to approximately 0 to 10 °C, the plated structures, normally being made of copper, will shrink, whereby the interaction between the plated structures and the insulating material on the master electrode will decrease, and the separation between the master electrode and the plated structures, and thus the substrate, will be facilitated. Normally, the material of the master electrode will be of a semiconducting or conducting material covered with an isolated material that also will shrink when lowering the temperature of the master electrode and the substrate. This will further facilitate the separation process, since the structure centre of the material of the master electrode is such that the shrinking has a direction away from the plated structures. When the plated structures and the material of the master electrode are separated by shrinking, electrolyte will be transported into the gap between the two, whereby separation is facilitated. In other words, the temperature is decreased from the temperature of plating before decreasing the interaction area between the master electrode and the substrate.

The temperature decrease from the plating temperature may be combined with the embodiments disclosed above in relation to Figs. 1 and 2, as well the embodiments disclosing the use of horizontal gas flow towards the interface between the master electrode and the substrate.

In yet another example not part of the invention, a back etching method is used wherein the direction of current is reversed in relation to the current direction during plating. Thus, a part of the plated structures will be etched away along the sidewalls, and the corresponding material transferred to the master electrode. In this way the interaction between the plated structures and the insulating material on the master electrode will decrease, and the separation between the master electrode and the plated structures, and thus the substrate, will be facilitated. When the plated structures and the insulating material are separated by reversing the current direction, electrolyte will be transported into the gap between the two, whereby separation is facilitated. In other words, the direction of current is reversed in relation to the current direction during plating before decreasing the interaction area between the master electrode and the substrate.

The back etching method may be combined with the embodiments disclosed above in relation to Figs. 1 and 2, the embodiments disclosing the use of horizontal gas flow towards the interface between the master electrode and the substrate, as well as the embodiments relating to the temperature decrease from the plating temperature.

In still another example not part of the invention a master electrode, arranged on a lower chuck, and a substrate, arranged on an upper chuck, are enclosed in a sealed ECPR chamber, in which chamber printing is performed. After printing the pressure in the ECPR chamber is increased during or while pulling the lower and upper chuck apart. The pressure in the ECPR chamber may be increased to a total pressure exceeding 1 bar, such as between 2 to 6 bars, i.e. an overpressure of 1 to 5 bars with respect to atmospheric pressure. In some embodiments, it is possible to increase the pressure even further. The increase in pressure will propagate through the electrolyte, positioned between the master electrode and the substrate, said electrolyte having a pressure of 1 bar before the pressure increase. In other words, the printing in the ECPR process is performed in a sealed ECPR chamber at a first pressure, and the pressure in the ECPR chamber is increased in relation to said first pressure before or while decreasing the interaction area between the master electrode and the substrate. Thus, the increased pressure will aid in the separation between the master electrode and the substrate. The pressure in the ECPR chamber may also be pulsed, meaning switching between a higher and a lower applied pressure, during pulling the lower and upper chucks apart, i.e. the master electrode and the substrate. In this way vibrations are created that will help in overcoming the friction between the master electrode and the substrate. In another embodiment ultrasonic or megasonic transducers are integrated in the process chamber or in the fluid supply lines going into the process chamber, said transducers are used to inject ultrasonic or megasonic waves creating vibrations that will help in overcoming the friction between the master electrode and the substrate.

The embodiments relating to increasing the pressure in the ECPR chamber may be combined with the embodiments disclosed above in relation to Figs. 1 and 2, the embodiments disclosing the use of horizontal gas flow towards the interface between the master electrode and the substrate, the embodiments relating to the temperature decrease from the plating temperature, as well as the embodiments relating to back etching.

It is readily understood that all references to lower/upper are merely for illustrative purposes, without any limiting effect on the scope of protection. Moreover, it should be realized that equivalent setups to those described may include setups having a substrate arranged on a lower chuck while the master electrode is mounted on an upper chuck, as well as setups in which the positions of the lower and upper chuck are switched.

In some embodiments, the master electrode and substrate are unloaded from the process chamber, i.e. from the bottom chuck and top chuck respectively, after ECPR printing before separation is performed. Subsequently, the embodiments for separation described in the present invention can be constructed and performed in a separate separation chamber, i.e. outside the ECPR processes chamber. This can for instance be beneficial for embodiments where the temperature is lowered to facility separation.

In the claims, the term "comprises/comprising" does not exclude the presence of other elements or steps. Furthermore, although individually listed, a plurality of means, elements or method steps may be implemented by e.g. a single unit or processor. Additionally, although individual features may be included in different claims, these may possibly advantageously be combined, and the inclusion in different claims does not imply that a combination of features is not feasible and/or advantageous. In addition, singular references do not exclude a plurality. The terms "a", "an", "first", "second" etc do not preclude a plurality. Reference signs in the claims are provided merely as a clarifying example and shall not be construed as limiting the scope of the claims in any way.

## Claims

1. A method for separating a master electrode (101, 201) and a substrate (102, 202) in an ECPR printing process after printing, the master electrode (101, 201) or the substrate (102, 202) being arranged on a first chuck (103, 104, 203, 204) and the other one of said master electrode (101, 201) and the substrate (102, 202) being arranged on a second chuck (103, 104, 203, 204), said master electrode (101, 201) and substrate (102, 202) having a planar interaction area during plating, said method comprising initiating separation at the edge of the master electrode (101, 201) and the substrate (102, 202); pulling a front side of the master electrode (101, 201) apart from a front side of the substrate (102, 202) such that the interaction area between the master electrode (101, 201) and the substrate (102, 202) is decreased continuously from the periphery of the master electrode (101, 201) and the substrate (102, 202) towards a centre of the master electrode (101, 201) or substrate (102, 202).

2. The method according to claim 1, wherein the first chuck (103, 104, 203, 204) and/or the second chuck (103, 104, 203, 204) has an inherent convex shape when the master electrode (101, 201) and the substrate (102, 202) have been separated, such that the first chuck (103, 104, 203, 204) and/or the second chuck (103, 104, 203, 204) strives towards its convex shape during separation, whereby separation is initiated at the periphery of the master electrode (101, 201) and/or the substrate (102, 202), while continuously decreasing the contact area between the two.

3. The method according to any of claims 1 to 2, comprising providing a horizontal gas flow (106, 206) towards the interface between the master electrode (101, 201) and the substrate (102, 202).

4. The method according to claim 3, wherein said gas flow is a flow of a gas selected from the group consisting of nitrogen, helium, or argon.

5. The method according to any of claims 1 to 4, comprising lowering the temperature from the temperature of plating before decreasing the interaction area.

6. The method according to claim 5, wherein the temperature is lowered from a plating temperature of 20 to 25 °C to 10 to 15 °C before decreasing the interaction area.

7. The method according to any of claims 1 to 6, comprising reversing the direction of current in relation to the current direction during plating before decreasing the interaction area.

8. The method according to any of claims 1 to 6, wherein the printing in the ECPR process is performed in a sealed ECPR chamber, and the ECPR chamber is provided with an overpressure before or while decreasing the interaction area.

9. The method according to any of claims 1 to 8, wherein the master electrode (101, 201) is a master electrode in an ECPR printing process.

## Patentansprüche

1. Verfahren zur Trennung einer Masterelektrode (101, 201) und eines Substrats (102, 202) in einem ECPR-Druckprozess nach dem Drucken, wobei die Masterelektrode (101, 201) oder das Substrat (102, 202) auf einer ersten Einspannvorrichtung (103, 104, 203, 204) angeordnet ist und das andere der Masterelektrode (101, 201) oder des Substrats (102, 202) auf einer zweiten Einspannvorrichtung (103, 104, 203, 204) angeordnet ist, wobei die Masterelektrode (101, 201) und das Substrat (102,202) während des Plattierens einen planaren Wechselwirkungsbereich aufweisen, wobei das Verfahren umfasst:
Beginnen der Trennung am Rand der Masterelektrode (101, 201) und des Substrats (102, 202);
Abziehen einer Vorderseite der Masterelektrode (101, 201) von einer Vorderseite des Substrats (101, 202), sodass der Wechselwirkungsbereich zwischen der Masterelektrode (101, 201) und dem Substrat (102, 202) kontinuierlich von dem Außenumfang der Masterelektrode (101, 201) und des Substrats (102, 202) zu einem Zentrum der Masterelektrode (101, 201) oder des Substrats (102, 202) hin verkleinert wird.

2. Verfahren nach Anspruch 1, wobei die erste Einspannvorrichtung (103, 104, 203, 204) und/oder die zweite Einspannvorrichtung (103, 104, 203, 204) eine inhärent konvexe Form aufweisen, wenn die Masterelektrode (101, 201) und das Substrat (102, 202) getrennt worden sind, sodass die erste Einspannvorrichtung (103, 104, 203, 204) und/oder die zweite Einspannvorrichtung (103, 104, 203, 204) während der Trennung zu ihrer konvexen Form streben, wobei die Trennung am Außenumfang der Masterelektrode (101, 201) und/oder des Substrats (102, 202) begonnen wird, während der Kontaktbereich zwischen den beiden kontinuierlich verkleinert wird.

3. Verfahren nach einem der Ansprüche 1 bis 2, umfassend das Zuführen eines horizontalen Gasstroms (106, 206) zu der Schnittstelle zwischen der Masterelektrode (101, 201) und dem Substrat (102, 202).

4. Verfahren nach Anspruch 3, wobei der Gasstrom ein Strom eines aus der aus Stickstoff, Helium oder Argon bestehenden Gruppe ausgewählten Gases ist.

5. Verfahren nach einem der Ansprüche 1 bis 4, umfassend das Senken der Temperatur von der Temperatur des Plattierens, bevor der Wechselwirkungsbereich verkleinert wird.

6. Verfahren nach Anspruch 5, wobei die Temperatur von einer Plattiertemperatur von 20 bis 25°C auf 10 bis 15°C gesenkt wird, bevor der Wechselwirkungsbereich verkleinert wird.

7. Verfahren nach einem der Ansprüche 1 bis 6, umfassend das Umkehren der Stromrichtung in Bezug zu der Stromrichtung während des Plattierens, bevor der Wechselwirkungsbereich verkleinert wird.

8. Verfahren nach einem der Ansprüche 1 bis 6, wobei das Drucken in dem ECPR-Prozess in einer abgedichteten Kammer durchgeführt wird und die ECPR-Kammer mit einem Überdruck versehen wird, bevor oder während der Wechselwirkungsbereich verkleinert wird.

9. Verfahren nach einem der Ansprüche 1 bis 8, wobei die Masterelektrode (101, 201) eine Masterelektrode in einem ECPR-Druckprozess ist.

## Revendications

1. Procédé pour séparer une électrode maître (101, 201) et un substrat (102, 202) dans un procédé d'impression ECPR après l'impression, l'électrode maître (101, 201) ou le substrat (102, 202) étant disposé sur un premier mandrin (103, 104, 203, 204) et l'autre élément parmi ladite électrode maître (101, 201) et ledit substrat (102, 202) étant disposé sur un second mandrin (103, 104, 203, 204), ladite électrode maître (101, 201) et ledit substrat (102, 202) possédant une zone d'interaction planaire au cours de l'électrodéposition, ledit procédé comprenant le fait de :
démarrer la séparation au bord de l'électrode maître (101, 201) et du substrat (102, 202) ;
tirer un côté avant de l'électrode maître (101, 201) à l'écart d'un côté avant du substrat (102, 202) d'une manière telle que la zone d'interaction entre l'électrode maître (101, 201) et le substrat (102, 202) diminue en continu à partir de la périphérie de l'électrode maître (101, 201) et du substrat (102, 202) en direction du centre de l'électrode maître (101, 201) ou du substrat (102, 202).

2. Procédé selon la revendication 1, dans lequel le premier mandrin (103, 104, 203, 204) et/ou le second mandrin (103, 104, 203, 204) possèdent une configuration convexe inhérente lorsque l'électrode maître (101, 201) et le substrat (102, 202) ont été séparés, d'une manière telle que le premier mandrin (103, 104, 203, 204) et/ou le second mandrin (103, 104, 203, 204) cherchent à atteindre leur configuration convexe au cours de la séparation, dans lequel la séparation est déclenchée à la périphérie de l'électrode maître (101, 201) et/ou du substrat (102, 202), tout en diminuant de manière continue la zone de contact entre les deux.

3. Procédé selon l'une quelconque des revendications 1 à 2, comprenant le fait de procurer un courant de gaz horizontal (106, 206) en direction de l'interface entre l'électrode maître (101, 201) et le substrat (102, 202).

4. Procédé selon la revendication 3, dans lequel ledit courant de gaz est un courant de gaz choisi parmi le groupe constitué par l'azote, l'hélium ou l'argon.

5. Procédé selon l'une quelconque des revendications 1 à 4, comprenant le fait d'abaisser la température à partir de la température de l'électrodéposition avant de diminuer la zone d'interaction.

6. Procédé selon la revendication 5, dans lequel on abaisse la température à partir d'une température d'électrodéposition de 20 à 25 °C jusqu'à une température de 10 à 15 °C avant de diminuer la zone d'interaction.

7. Procédé selon l'une quelconque des revendications 1 à 6, comprenant le fait de renverser la direction du courant par rapport à la direction du courant au cours de l'électrodéposition, avant de diminuer la zone d'interaction.

8. Procédé selon l'une quelconque des revendications 1 à 6, dans lequel l'impression dans le procédé ECPR est mise en oeuvre dans une chambre ECPR fermée de manière hermétique, et la chambre ECPR est pourvue d'une surpression avant ou pendant la diminution de la zone d'interaction.

9. Procédé selon l'une quelconque des revendications 1 à 8, dans lequel l'électrode maître (101, 201) est une électrode maître dans un procédé d'impression ECPR.
